# EUROPEAN PATENT SPECIFICATION

(11) **EP 1 187 309 B1**
(45) Date of publication and mention of the grant of the patent: **07.07.2010**
(21) Application number: 01119839.7
(22) Date of filing: 16.08.2001
(51) Int. Cl.: H03B 5/36

(54) **Voltage-controlled oscillator, IC chip for voltage-controlled oscillator, resistance setting apparatus, and resistance setting method**
Spannungsgesteuerter Oszillator und integrierter Schaltkreischip dafür, Verfahren und Vorrichtung zur Setzung eines Widerstands
Oscillateur commandé en tension, puce de circuit intégré pour un tel oscillateur, dispositif de réglage de résistance et méthode de réglage de résistance

(30) Priority: 29.08.2000 JP 2000259870
(43) Date of publication of application: 13.03.2002
(73) Proprietor: Seiko Epson Corporation, Shinjuku-ku Tokyo 163-0811 (JP)
(72) Inventor: Fujii, Yoichi, c/o Seiko Epson Corporation, Suwa-shi, Nagano-ken 392-8502 (JP); Kinoshita, Hiroshi, c/o Seiko Epson Corporation, Suwa-shi, Nagano-ken 392-8502 (JP); Endo, Takashi, c/o Seiko Epson Corporation, Suwa-shi, Nagano-ken 392-8502 (JP)
(74) Representative: MERH-IP Matias Erny Reichl Hoffmann

(56) References cited:
- US-A- 5 347 237
- US-A- 5 805 029
- CARR J: "CRYSTALS MADE CLEAR II" ELECTRONICS WORLD AND WIRELESS WORLD, REED BUSINESS PUBLISHING, SUTTON, SURREY, GB, vol. 105, no. 1762, October 1999 (1999-10), pages 849-855, XP000927849 ISSN: 0959-8332

## Description

The present invention relates to voltage-controlled oscillators which are used in, for example, wireless communication apparatuses, video apparatuses, and measuring instruments, and more particularly relates to a voltage-controlled oscillator that requires a precise frequency change versus control voltage characteristic.

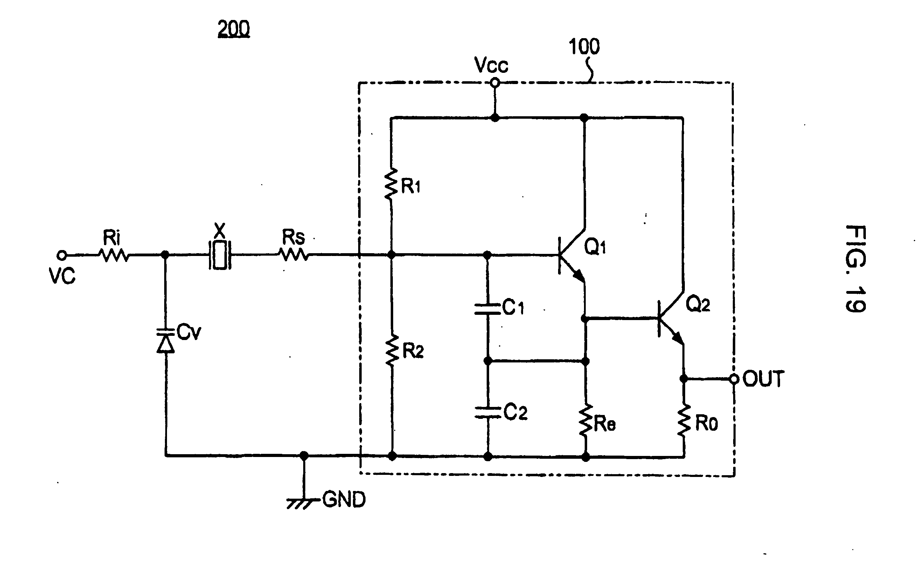

In Fig. 19, the structure of a conventional general voltage-controlled oscillator is shown.

A voltage-controlled piezoelectric oscillator 200 (simply referred to as "VCO" hereinafter) includes an input resistor Ri connected to a frequency control terminal VC, a piezoelectric resonator X, a variable capacitance diode (varactor) Cv, an oscillation-amplitude adjusting resistor Rs, and an oscillator circuit 100.

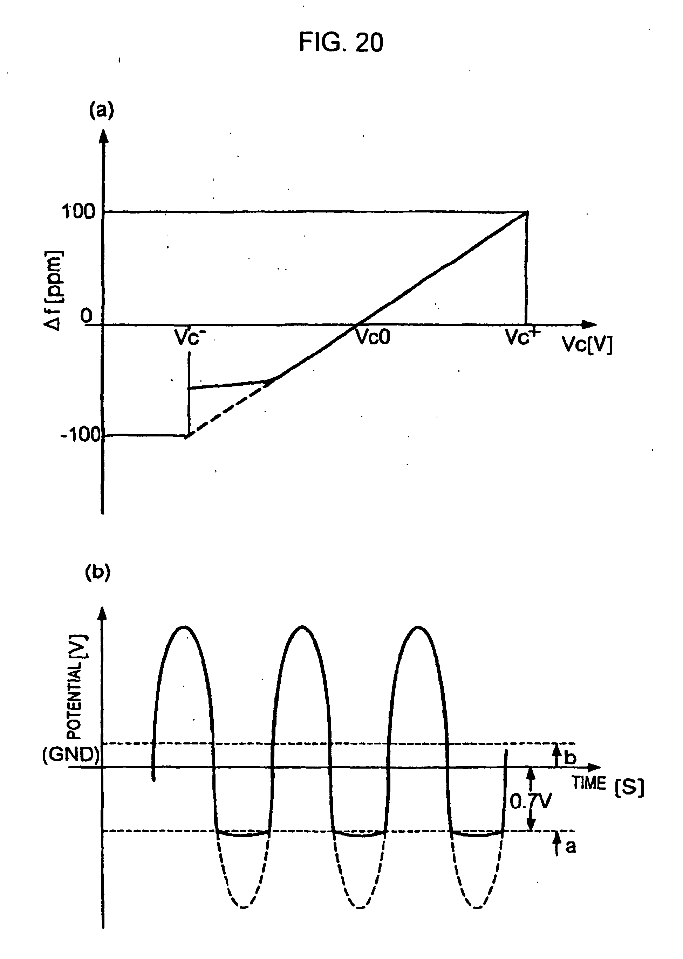

In the VCO 200 as arranged above, application of a control voltage Vc to the frequency control terminal VC changes the capacitance of the varactor Cv, thus adjusting the oscillation frequency f determined by the resonance with the resonator X. In the VCO 200, as shown by the frequency change versus control voltage characteristic (Δf-V-characteristic) indicated by dotted lines in Fig. 20(a), the voltage value of the control voltage Vc is changed within a predetermined range (range from Vc- to Vc+ with respect to a reference control voltage Vc0), and hence the oscillation frequency f of an oscillation signal S outputted from an output terminal OUT is changed linearly within a predetermined range (range from -100 to +100 ppm with respect to a reference frequency f0, which corresponds to the reference control voltage Vc0). In Fig. 20(a), the control voltage Vc is plotted on the abscissa, and the frequency deviation Δf of the oscillation frequency f (frequency deviation Δf = (f - f0)/f0) is plotted on the ordinate.

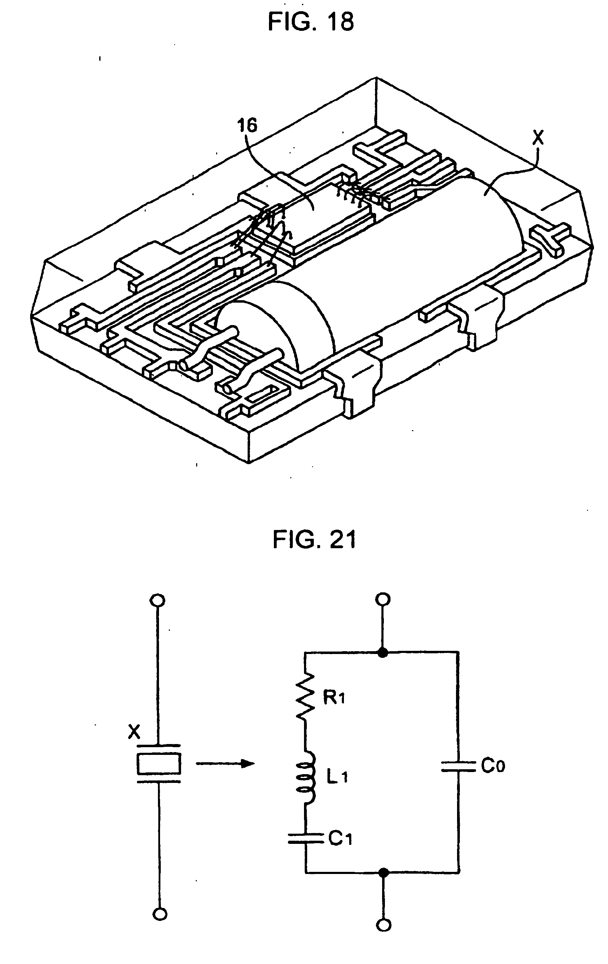

The resonator X can be replaced by the equivalent circuit shown in Fig. 21. Even when at the same frequency, when the resonator X is formed of, for example, a crystal strip, the equivalent circuit constants may vary according to a difference in shape, such as a rectangular shape or a disk shape, a difference in size, or the like.

For example, when the resistance of resistor R1 in the equivalent circuit is smaller than the resistance of the normal resonator X, the impedance of an oscillator loop consisting of the varactor Cv, the resonator X, the oscillation-amplitude adjusting resistor Rs, and oscillation capacitors C1 and C2 is reduced, whereas the oscillation amplitude of the oscillation signal is increased. In such a case, when the control voltage Vc is set to a low level, a desired frequency may not be achieved since the Δf-V-characteristic is not linear.

Specifically, as indicated by solid lines in Fig. 20(a), when the control voltage Vc applied to the frequency control terminal VC is changed from a high level (Vc+) to a low level (Vc-), the Δf-V-characteristic becomes non-linear in the vicinity of the low level.

As shown in Fig. 20(b), the cause of this is that when the control voltage Vc approaches a low level, the capacitance of the varactor Cv increases (the impedance is reduced), and the negative side of the oscillation amplitude is clipped by the forward voltage (approximately -0.7 V) of the varactor Cv.

< shows time on the abscissa and the amplitude of the oscillation signal generated in the oscillator loop on the ordinate.

When the negative side of the oscillation amplitude is clipped by the forward voltage, the control voltage Vc applied to the varactor Cv is greater than the control voltage Vc applied to the frequency control terminal VC by an average potential (see arrow b in Fig. 20(b)). Hence, there is a difference between the control voltage Vc applied to the varactor Cv and the actual voltage of the varactor Cv. This results in loss of linearity of the Δf-V-characteristic as the control voltage Vc approaches Vc-(GND).

In the VCO 200, when the components other than the resonator X and the varactor Cv are formed as an IC chip, the resistor Rs has a fixed value. It is therefore necessary to provide a plurality of IC chips in order that each IC chip has the resistor Rs with a resistance value appropriate for a respective resonator X whose oscillation frequency f may differ from that of other resonators. As a result, the cost is increased.

In view of the above circumstances, it is an object of the present invention to provide a voltage-controlled oscillator, an IC chip for a voltage-controlled oscillator, a resistance setting apparatus, and a resistance setting method, which are capable of improving the linearity of the frequency change or frequency deviation versus control voltage characteristic and increasing the range of frequency that can be varied by a control voltage.

The document CARR J: "CRYSTALS MADE CLEAR II" ELECTRONICS WORLD AND WIRELESS WORLD, REED BUSINESS PUBLISHING, SUTTON, SURREY, GB, Vol. 105, No. 1762, October 1999 (1999-10) pages 849-855, XP000927849 ISSN: 0959-8332 discloses a Miller oscillator having a crystal resonator and a variable capacitor connected in parallel. A resistor is provided in an oscillator loop including said resonator (X) and variable capacitance diode (Cv). According to the documents the value of this resistor is set to the highest value that permits sure starting of the oscillator.

US-A-5,805,029 discloses a digitally adjustable oscillator having a quartz crystal. N basic cells are connected in parallel with the quartz crystal with a feedback resistor connected in parallel. Each cell comprises two capacitance stages having two capacitors connected in parallel with the quartz crystal, and each having one terminal coupled to ground potential. Each basic cell further includes a corresponding inverter stage connected in parallel with the quartz crystal. Each inverter stage comprises two series-connected amplifying transistors of opposite conductivity types. Each of the amplifying transistors has a corresponding switching transistor of the same conductivitiy type connected in series operable as switching devices. A resistor is connected to the output of the inverter stage. The first capacitor A control signal source provides control signals to control the opening and closing of each of the switches within the oscillator. With each control signal, the switches of the respective basic cells are closed. The number of closed switches in the basic cells determines the effective load capacitance of the quartz crystal, and thus the resonant frequency of the crystal oscillator. To achieve stable oscillation at a given resonant frequency, the transconductance must be adapted to the respective resonant frequency. This is accomplished by turning on the switching transistors with a common control signal at the same time the capacitors are switched into circuit. Thus, the respective inverter stage and the resistorfollowing that stage are switched into the circuit simultaneously with the capacitors. The inverter stage ensures a suitable gain at the changed resonance frequency, and the resistor ensures a constant amplitude of oscillation. The value of the resistor is chosen depending on the gain of the inverter stage and, thus, on the capacitance stages and the values of the amplifying transistors so that a constant amplitude of oscillation is achieved.

This object is achieved with a voltage-controlled oscillator as claimed in claim 1 Preferred embodiments of the invention are defined in the dependent claims.

Preferred embodiments of the present invention will be described below with reference to the drawings.
- Fig. 1: is a diagram showing the principle of a VCO of a first embodiment.
- Fig. 2: is a perspective view of the VCO of the first embodiment.
- Fig. 3: illustrates cases when switches are formed of semiconductor devices.
- Fig. 4: is a graph showing a Af-V-characteristic of the first embodiment.
- Fig. 5: is a graph showing oscillation amplitude of the first embodiment.
- Fig. 6: is a circuit diagram showing the VCO of the first embodiment to which an adjusting device is connected.
- Fig. 7: is a block diagram of the structure of the adjusting device.
- Fig. 8: illustrates the correspondence concerning signals included in the adjusting device.
- Fig. 9: is a flowchart showing a resistor setting process performed by the adjusting device.
- Fig. 10: includes graphs showing a Δf-V-characteristic and potentials at the cathode side of an example (f0 = 40 MHz and Rs = 0 Ω) of the first embodiment.
- Fig. 11: includes graphs showing a Δf-V-characteristic and potentials at the cathode side of an example (f0 = 40,MHz and Rs = 100 Ω) of the first embodiment.
- Fig. 12: includes graphs showing a Δf-V-characteristic and potentials at the cathode side of an example (f0 = 80 MHz and Rs = 0 Ω) of the first embodiment.
- Fig. 13: includes graphs showing a Δf-V-characteristic and potentials at the cathode side of an example (f0 = 80 MHz and Rs = 30 Ω) of the first embodiment.
- Fig. 14: is a circuit diagram of a VCO of a second embodiment.
- Fig. 15: is a circuit diagram of a VCO of a third embodiment.
- Fig. 16: is a circuit diagram of a VCO of a first modification.
- Fig. 17: is a circuit diagram of a VCO of a second modification.
- Fig. 18: is a perspective view of a VCO of a third modification.
- Fig. 19: is a circuit diagram of a VCO of the related art.
- Fig. 20: includes graphs showing a Δf-V-characteristic and oscillation amplitude of the related art.
- Fig. 21: is a circuit diagram of an equivalent circuit of a piezoelectric resonator.

### [1] First Embodiment

### [1.1] Schematic Structure of First Embodiment

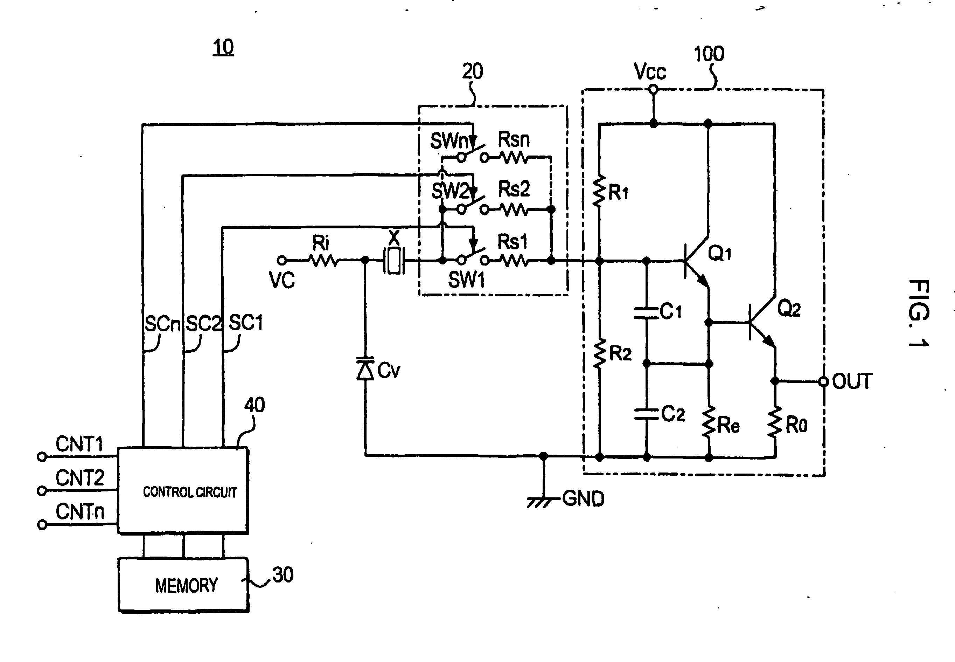

Fig. 1 shows the structure of a VCO 10 of a first embodiment.

The VCO 10 includes a frequency control terminal VC for applying a control voltage Vc for changing the oscillation frequency f of an oscillation signal S outputted from an output terminal OUT; an input resistor Ri, one end of which is connected to the frequency control terminal VC to suppress influence on an oscillation frequency control circuit (not shown), which is to be connected by a user to the frequency control terminal VC; a piezoelectric resonator X, one end of which is connected to the other end of the input resistor Ri; a varactor Cv, the cathode terminal of which is connected to the node between the input resistor Ri and the resonator X; a resistor circuit 20 for adjusting the oscillation frequency, having one end connected to the other end of the resonator X; an oscillator circuit 100 connected to the other end of the resistor circuit 20; a memory 30; and a control circuit 40.

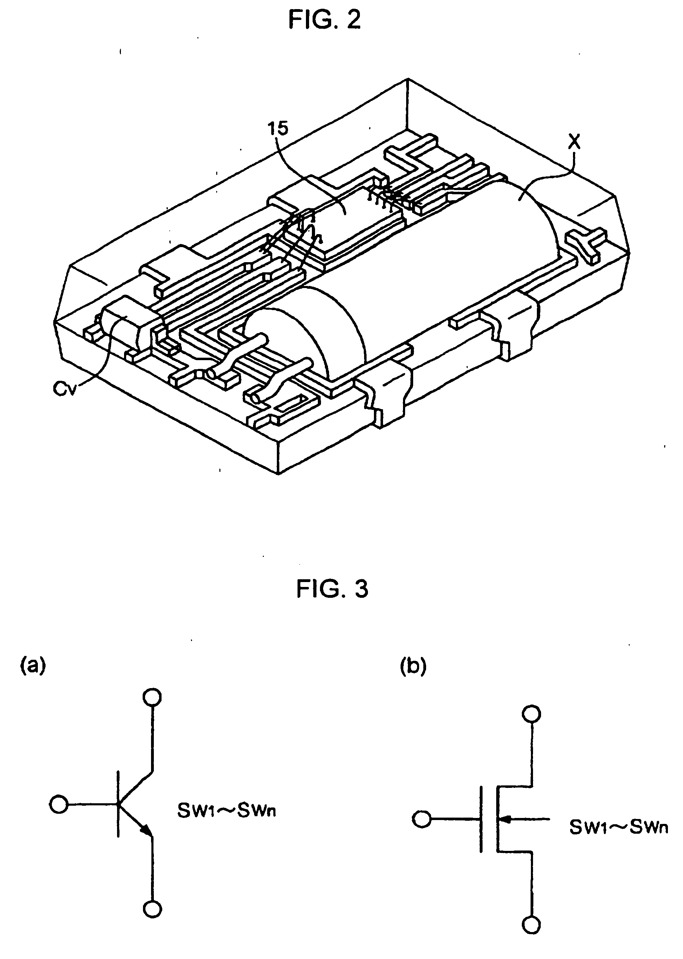

As shown in Fig. 2, the components of the VCO 10 other than the resonator X and the varactor Cv are formed as an IC chip 15. The IC chip 15, the resonator X, and the varactor Cv are mold-sealed. Terminals exposed to the outside include the frequency control terminal VC; control terminals CNT1 to CNTn; a high-potential power supply terminal VCC; the output terminal OUT; and a low-potential power supply terminal GND.

### [1.2] Structure of Each Section

### The structure of each section will be described in detail.

### [1.2.1] Structure of Oscillator Circuit 100

The oscillator circuit 100 includes a first bias resistor R1, one end of which is connected to the high-potential power supply terminal VCC, and the other end is connected to the resistor circuit 20; a second bias resistor R2, one end of which is connected to the node between the resistor circuit 20 and the first bias resistor R1, and the other end is connected to the low-potential power supply terminal GND; an NPN transistor Q1, the base terminal of which is connected to the node between the resistor circuit 20 and the first bias resistor R1, and the collector terminal is connected to the terminal VCC; an emitter resistor Re, one end of which is connected to the emitter terminal of the NPN transistor Q1, and the other end is connected to the terminal GND; an NPN transistor Q2, the base terminal of which is connected to the node between the emitter terminal of the NPN transistor Q1 and the emitter resistor Re, and the collector terminal is connected to the terminal VCC; an emitter resistor R0, one end of which is connected to the emitter terminal of the NPN transistor Q2, and the other end is connected to the terminal GND; a first oscillation capacitor C1, one end of which is connected to the node between the base terminal of the NPN transistor Q1 and the resistor circuit 20, and the other end is connected to the node between the emitter terminal of the NPN transistor Q1 and the emitter resistor Re; and a second oscillation capacitor C2, one end of which is connected to the node between the emitter terminal of the NPN transistor Q1 and the emitter resistor Re, and the other end is connected to the terminal GND.

### [1.2.2] Structure of Resistor Circuit 20

The resistor circuit 20 includes oscillation-amplitude adjusting resistors Rs1 to Rsn and switches SW1 to SWn connected to the oscillation-amplitude adjusting resistors Rs1 to Rsn, respectively. The switches SW1 to SWn are for connecting or disconnecting the resistors Rs1 to Rsn, based on resistor connection control signals SC1 to SCn outputted from the control circuit 40. The resistance values of the resistors Rs1 to Rsn may differ from one another or may be the same.

When the resistance values of the resistors Rs1 to Rsn differ from one another, for example, when the values are: Rs1 = 10 Ω, Rs2 = 20 Ω, Rs3 = 30 Ω, ..., and when the switches are appropriately turned on, resistance values of 10 Ω, 20 Ω, 30 Ω, ... can be obtained.

When a plurality of switches are turned on, for example, when the switches which are associated with resistors Rs1 (10 Ω) and Rs2 (20 Ω), respectively, are turned on, a total value of 6.7 Ω is set. When switches which are associated with resistors Rs1 (10 Ω) and Rs3 (30 Ω), respectively, are turned on, a total value of 7.5 Ω is set. When the switches which are associated with resistors Rs1 (10 Ω), Rs2 (20 Ω), and Rs3 (30 Ω), respectively, are turned on, a total value of 5.4 Ω is set. In this manner, the resistance can be set more finely.

In contrast, when the resistance values of the resistors Rs1 to Rsn are all equal, for example, 100 Ω, by increasing the number of switches to be turned on from among the switches SW1 to SWn corresponding to the resistors Rs1 to Rsn, the resistance of the resistor circuit 20 becomes 100 Ω, 50 Ω, 33 Ω, 25 Ω, 20 Ω, ...

By connecting the resistor circuit 20 between the resonator X and the oscillator circuit 100, an oscillator loop, which consists of the resonator X, the varactor Cv, and the oscillator circuit 100, is formed. By adjusting the resistance of the resistor circuit 20, the oscillation amplitude can be controlled.

Concerning the switches SW1 to SWn, when the VCO 10 is formed into an IC, the following arrangement can be configured in accordance with a semiconductor manufacturing process to be used.

When a bipolar process is used as the semiconductor manufacturing process, as shown in Fig. 3(a), the switches SW1 to SWn each have a bipolar transistor structure.

When a CMOS process is used as the semiconductor manufacturing process, as shown in Fig. 3(b), the switches SW1 to SWn each have a MOS transistor structure.

When a combination bipolar and CMOS process (Bi-CMOS process) is used, which is frequently used as the semiconductor manufacturing process for a high-frequency IC, the switches SW1 to SWn can have either a bipolar transistor structure as shown in Fig. 3(a) or a MOS transistor structure as shown in Fig. 3(b).

In terms of reducing the current consumption, it is more advantageous to employ the MOS transistor structure, which does not require a continuous flow of current in order to turn a transistor on and to keep it turned on. Since the MOS transistor is a voltage-controlled device, it is only necessary to apply, to the gate terminal, a voltage at a sufficient level to turn the MOS transistor and to keep it turned on. There is no current flow from the gate terminal to the source terminal side. In contrast, when the bipolar transistor structure is employed, it is necessary that a sufficient current flows between the base terminal and the emitter terminal, in order to reduce the on-resistance of the transistor in a selection state.

### [1.2.3] Memory 30

The memory 30 can be formed of a nonvolatile semiconductor memory, such as an EEPROM, which is an electrically erasable type memory, an EPROM, which can be erased by ultraviolet light, a fuse-type ROM, which is a fuse type memory, or the like. In the memory 30, control data DR for turning on/off the switches SW1 to SWn, in order to set the resistance of the resistor circuit 20, is stored.

The control data DR is written to the memory 30 through the control circuit 40 prior to factory shipment. When the VCO 10 is turned on, the resistor connection control signals SC1 to SCn for turning on/off the switches SW1 to SWn are generated by the control circuit 40.

### [1.2.4] Control Circuit 40

When adjusting the resistance of resistor circuit 20, which is set prior to factory shipment, the control circuit 40 turns on/off the switches SW1 to SWn of the resistor circuit 20 based on a control signal Rcon, which is inputted from the outside through the control terminals CNT1 to CNTn. When adjustment is completed, the control circuit 40 stores the control data DR in the memory 30 based on a resistor confirming signal Dcon. In normal operation, the control circuit 40 generates the control signals SC1 to SCn based on the control data DR stored in the memory 30 and turns on/off the switches SW1 to SWn based on the control signals SC1 to SCn.

### [1.3] Operation of Resistor Circuit 20

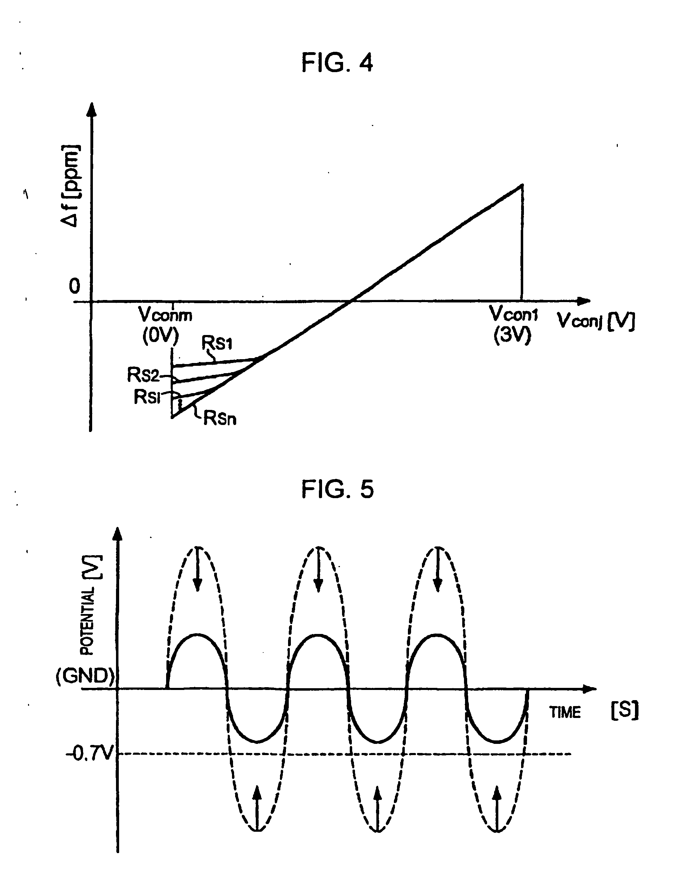

Referring to Figs. 4 and 5, the operation of the resistor circuit 20 is described.

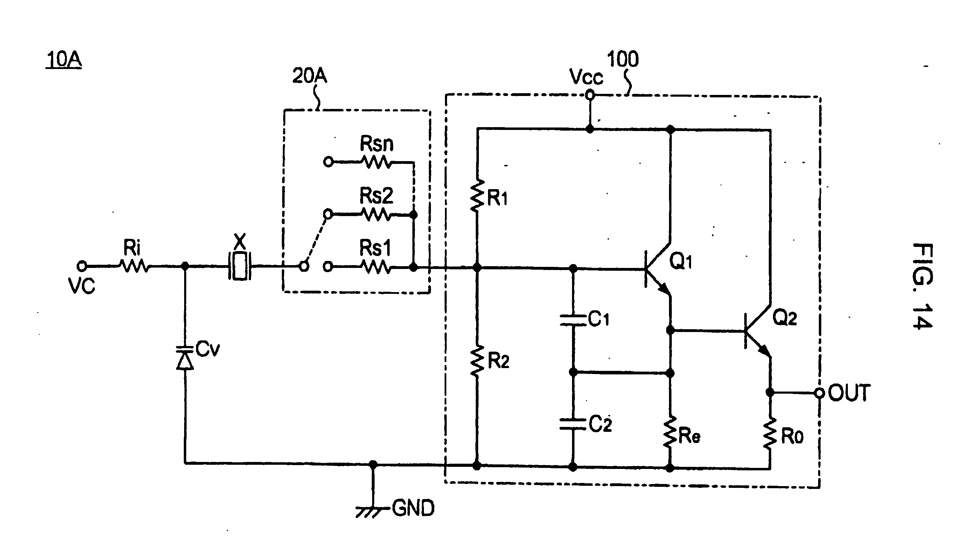

Fig.14 shows the Δf-V-characteristic for each preset resistance Rsi (i: 1 to n) when the voltage level of a control signal Vconj applied to the frequency control terminal VC is changed from a high level to a low level. Fig. 5 shows the amplitude of an oscillation signal in the oscillator loop.

The resistor circuit 20 connected in the oscillator loop changes the impedance of the oscillator loop based on the selected resistance from among the resistors Rs1 to Rsn, thereby adjusting the oscillation amplitude. In the following description, the effective resistance of the resistor circuit 20 will be referred to as Rs.

As described in the prior art, when the control voltage Vc is reduced, and when the amplitude is larger than that of the forward voltage (approximately -0.7 V) of the varactor Cv, that portion is clipped. As a result, there is a difference between the applied control voltage Vc and the actual voltage of the varactor Cv.

In this embodiment, by gradually increasing the resistance Rs of the resistor circuit 20, as indicated by arrows in Fig. 5, the oscillation amplitude generated in the oscillator loop is gradually reduced. Fig. 4 shows the variation in the Δf-V-characteristic.

By setting the resistance Rs of the resistor circuit 20 so that the oscillation amplitude becomes lower than the forward voltage of the varactor diode Cv (for example, 0.5 V), the Δf-V-characteristic becomes linear. As a result, the range within the frequency can be changed by the control voltage Vc is increased.

### [1.4] Operation of Resistor Adjustment

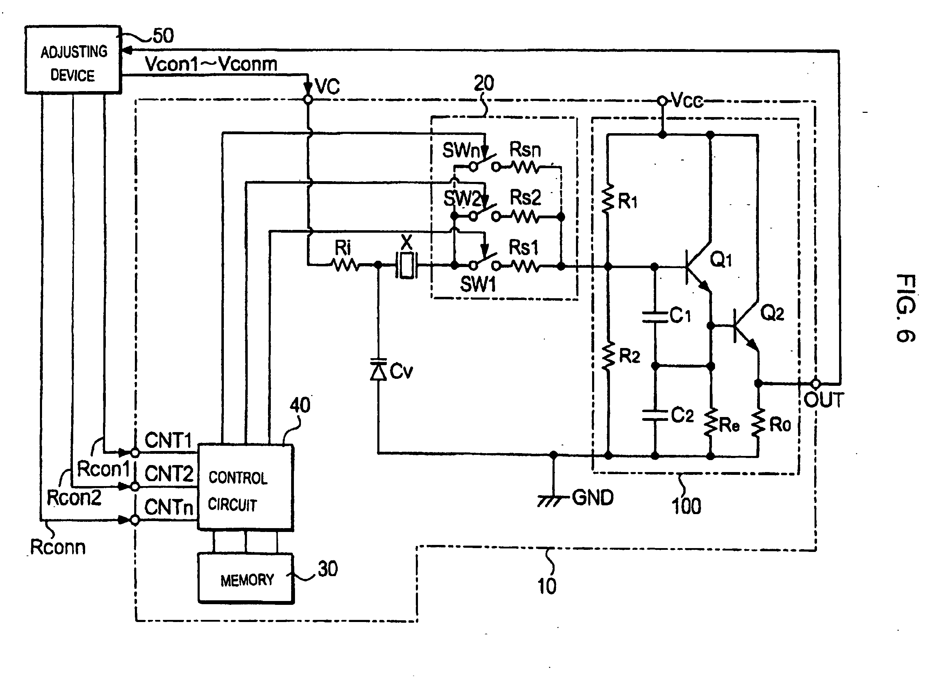

The adjustment operation performed prior to factory shipment will now be described with reference to Figs. 6 to 9.

### [1.4.1] Structure of Adjusting device

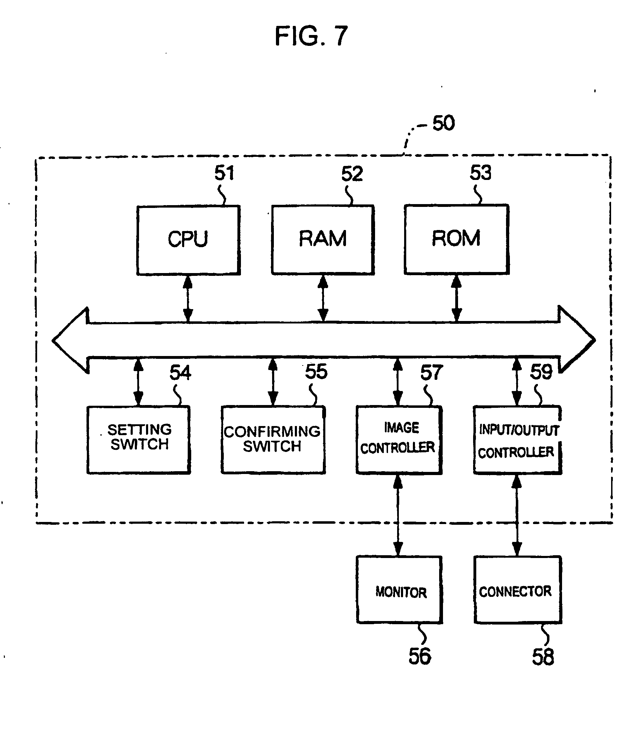

An adjusting device 50 shown in Fig. 6 will be described with reference to Fig. 7.

As shown in Fig. 7, the adjusting device 50 is formed of a microcomputer. The adjusting device 50 includes a CPU 51, a RAM 52, a ROM 53, a switch 54, a confirming switch 55, an image controller 57 connected to a monitor 56, and an input/output controller 59 connected to a connector 58.

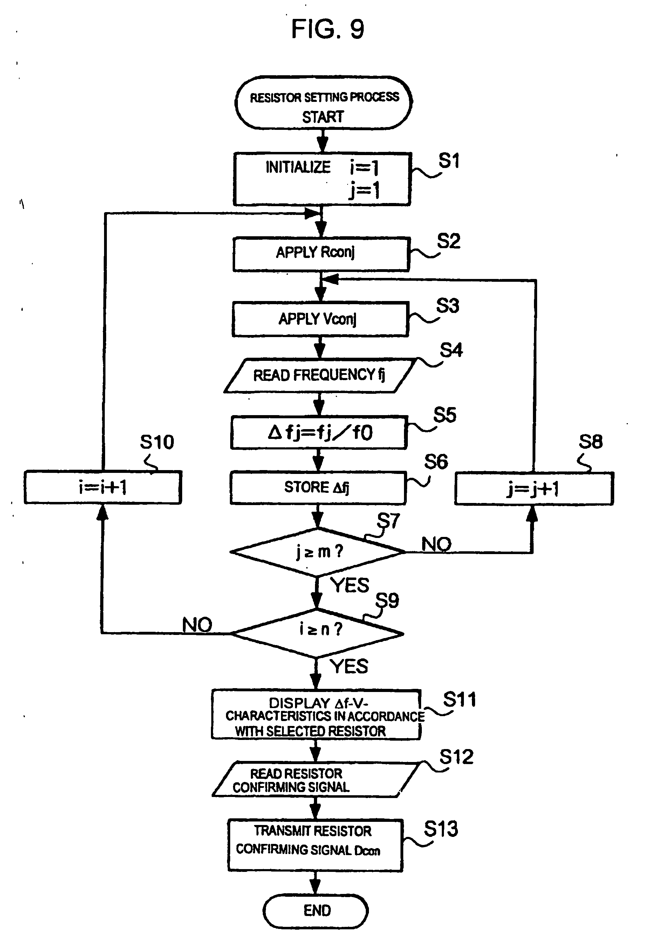

The ROM 53 is a read-only program memory which stores a resistor setting program such as that shown in Fig. 9 and various parameters for performing the program. The CPU 51 executes the program read from the ROM 53 to control signals (the control signal Rcon, the control signal Vcon, etc.) outputted from the input/output controller 59. The RAM 52 is used as a work area or the like when the CPU 51 performs the program.

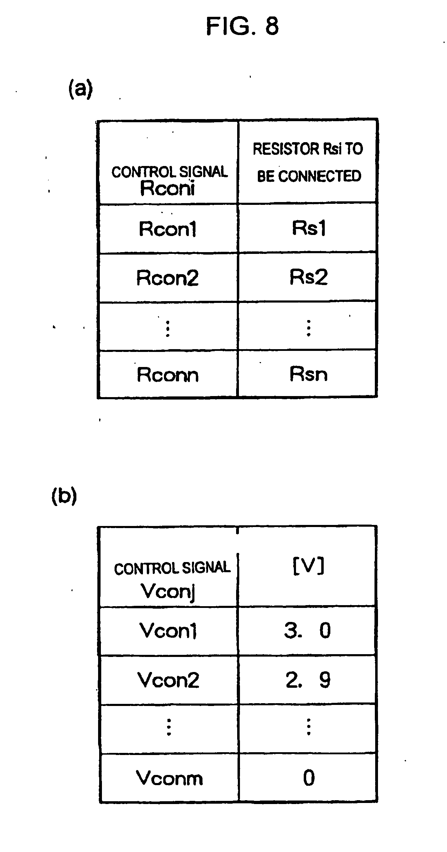

Various parameters stored in the ROM 53 include values for the control signal Rcon and the control signal Vcon. Fig. 8 shows the values that correspond to the various signals.

For example, Fig. 8(a) shows values that correspond to the control signals Rcon. A control signal Rcon1 turns on the switch SW1 of the resistor circuit 20 and connects the resistor Rs1 to the oscillator loop; a control signal Rcon2 turns on the switch SW2 of the resistor circuit 20 and connects the resistor Rs2 to the oscillator loop; ...; and a control signal Rconn turns on the switch SWn of the resistor circuit 20 and connects the resistor Rsn to the oscillator loop.

For example, Fig. 8(b) shows voltage values that correspond to the control signal Vcon. A control signal Vcon1 has voltage of Vc = 3V; a control signal Vcon2 has a voltage of Vc = 2.9V; ...; and a control signal Vconm has a voltage of Vc = 0V. This voltage is outputted to the frequency control terminal VC.

The switch 54 and the confirming switch 55 are for activating the adjusting operation of the adjusting device 50. The switch 54 and the confirming switch 55 are provided on a casing (not shown) of the adjusting device 50.

When an operator turns on the switch 54, an enable signal is supplied to the control circuit 40 of the VCO 10, thus allowing the control signal Rcon to be supplied to the switches SW1 to SWn through the control circuit 40. Also in the memory 30, writing of the control data DR, which corresponds to the control signal Rcon, is permitted.

The confirming switch 55 is operated by the operator by selecting a desired resistor in accordance with the Δf-V-characteristic based on each resistor displayed on the monitor 56. When the switch 55 is operated, the resistor confirming signal Dcon is outputted. The CPU 51 transmits the resistor confirming signal Dcon to the control circuit 40, and the control circuit 40 in turn writes the control data DR which corresponds to the confirmed resistor into the memory 30.

### [1.4.2] Adjusting Operation

The adjusting operation using the adjusting device 50 will now be described with reference to a flowchart shown in Fig. 9. The resistance values of the resistors Rs1 to Rsn forming the resistor circuit 20 are, for example, 10 Ω, 20 Ω, ..., 100 Ω, respectively.

The operator connects the VCO 10 to the connector 58 of the adjusting device 50 and turns on the switch 54. At the same time, the CPU 51 reads the resistor setting program and various parameters (the values for the control signals Rcon and the values for the control signals Vcon) which are stored in the ROM 53 into the RAM 52.

The CPU 51 starts a resistor setting process in accordance with the resistor setting program.

The CPU 51 initializes indices i and j stored in a memory region of the RAM 52 to i = 1 and j = 1 (step S1).

Next the CPU 51 reads the value for control signal Rcon1 from the parameters stored in the RAM 52 and supplies the control signal Rcon1 to the control terminal CNT1 through the input/output controller 59 and the connector 58 (step S2).

In response to the control signal Rcon1, the control circuit 40 of the VCO 10 turns on the switch SW1 of the resistor circuit 20 and connects the resistor Rs1 to the oscillator loop.

Next, the CPU 51 reads the voltage value for control signal Vcon1 (for example 3V) from the parameters stored in the RAM 52 and applies the corresponding voltage as control signal Vcon1 to the frequency control terminal VC, through the input/output controller 59 and the connector 58 (step S3).

In the VCO 10, the resistor Rs1 adjusts the oscillation amplitude of the oscillator loop, and subsequently the capacitance of the varactor Cv is changed by the applied control signal Vcon1. Thus, the oscillation signal S, which has a oscillation frequency f1 determined by the resonance with the resonator X, is outputted.

The CPU 51 reads the oscillation frequency f1 from the output terminal OUT (step S4) and computes the frequency deviation Δf1 (Δf1 = (f1 - f0)/f0) with respect to the reference frequency f0 (step S5). Also, the CPU 51 stores the frequency deviation Δf1 in the RAM 52 (step S6).

The CPU 51 determines whether or not the index j has reached m (step S7). If the index j has not reached m (NO in step S7), it means that the measurement of the frequency deviation Δfj has not been completed, in which the control voltage Vc is gradually decreased from 3V to 0.1V, while the resistor circuit 20 is set to resistor Rs1. Thus, the process proceeds to step S8.

The CPU 51 increases the index j by one by computing j = j + 1 (step S8). The CPU 51 repeats the processing from step S3 to step S8 until the determination in step S7 becomes affirmative. Every time the processing is repeated, the CPU 51 stores the frequency deviation Δfj in correspondence with j in the RAM 52.

In contrast, when the index j has reached m (YES in step S7), the CPU 51 determines whether or not the index i has reached n (step S9). If the index i has not reached n (NO in step S9), it means that the measurement of the frequency deviation Δfj has not been completed, in which the control signal Vconj is gradually decreased from 3V to 0.1V for each of the resistors Rs1 to Rsn of the resistor circuit 20. Thus, the process proceeds to step S10.

The CPU 51 increases the index i by one by computing i = i + 1 (step S10). The CPU 51 repeats the processing from step S2 to S9 until the determination in step S9 becomes affirmative. Every time step S6 is performed, the CPU 51 sequentially stores the frequency deviation Δfj in correspondence with the resistor Rsj in the RAM 52.

If the index i has reached n (YES in step S9), the CPU 51 determines that the measurement of the frequency deviation Δfj has been completed for all combinations of control signals Vconj and control signals Rcon.

The CPU 51 reads the frequency deviation Δfj stored in the RAM 52 and displays, as shown in Fig. 4, the Δf-V-characteristic for each resistor on the monitor 56 through the image controller 57 (step S11).

The operator looks at the Δf-V-characteristic for each resistor and operates the confirming switch 55 so as to select a desired resistance. Accordingly, the CPU 51 reads the resistor confirming signal Dcon in response to the operation of the confirming switch 55 (step S12).

In order to connect the confirmed (selected) resistor Rsi to the oscillator loop, the CPU 51 transfers the resistor confirming signal Dcon, which is to turn on switch SWi corresponding to the resistor Rsi, to the control circuit 40 through the input/output controller 59 and the connector 58 (step S13). In response to the resistor confirming signal Dcon, the control circuit 40 stores the control data DR for connecting the confirmed resistor Rsi to the oscillator loop.

Accordingly, by using the adjusting device 50, the appropriate resistor Rsi of the resistor circuit 20 can be selected and confirmed easily.

### [1.5] Specific Example

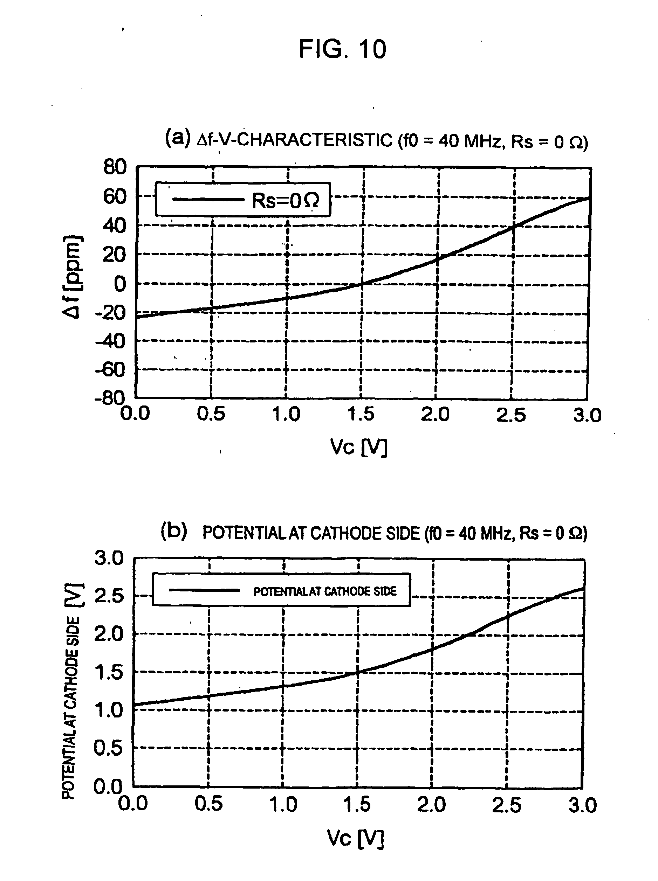

In Figs. 10 to 13, the actual experimental results are shown.

In Figs. 10(a), 11(a), 12(a), and 13(a), the Δf-V-characteristic in accordance with conditions concerning the reference frequency f0 and the resistance Rs of the resistor circuit 20 are shown. In Figs. 10(b), 11(b), 12(b), and 13(b), the potential (oscillation amplitude) at the cathode side versus the control voltage Vc (V-V-characteristic) is shown.

In these cases, the resistance values of the resistors Rs1 to Rsn of the resistor circuit 20 are 10 Ω, 20 Ω, ..., 100 Ω, respectively.

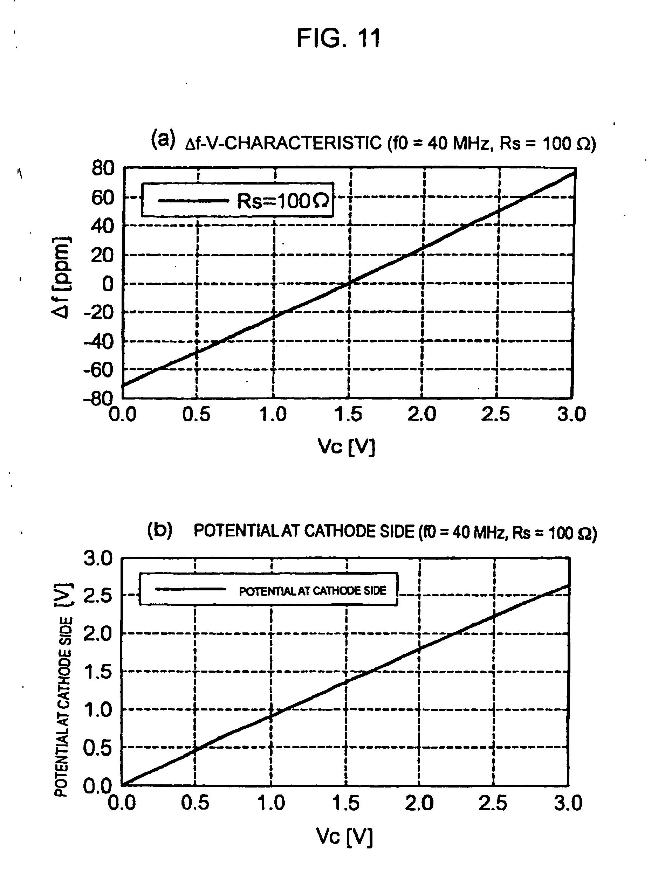

In Figs. 10 and 11, cases in which the reference frequency f0 is 40 MHz are shown.

As shown in Fig. 10, when the resistance Rs of the resistor circuit 20 is 0 Ω, the V-V-characteristic loses linearity when the control voltage Vc is approximately 1.7 V. Accordingly, the Δf-V-characteristic loses linearity when the control voltage Vc is approximately 1.7 V. Thus, the frequency can be changed by the control voltage Vc within a range from + 10 to 60 ppm.

When the resistance Rs of the resistor circuit 20 is set to 100 Ω, as shown in Fig. 11, the potential at the cathode side changes linearly with a change in Vc. Accordingly, the Δf-V-characteristic is also linear. Thus, the frequency can be changed by the control voltage Vc within a ange of ±70 ppm.

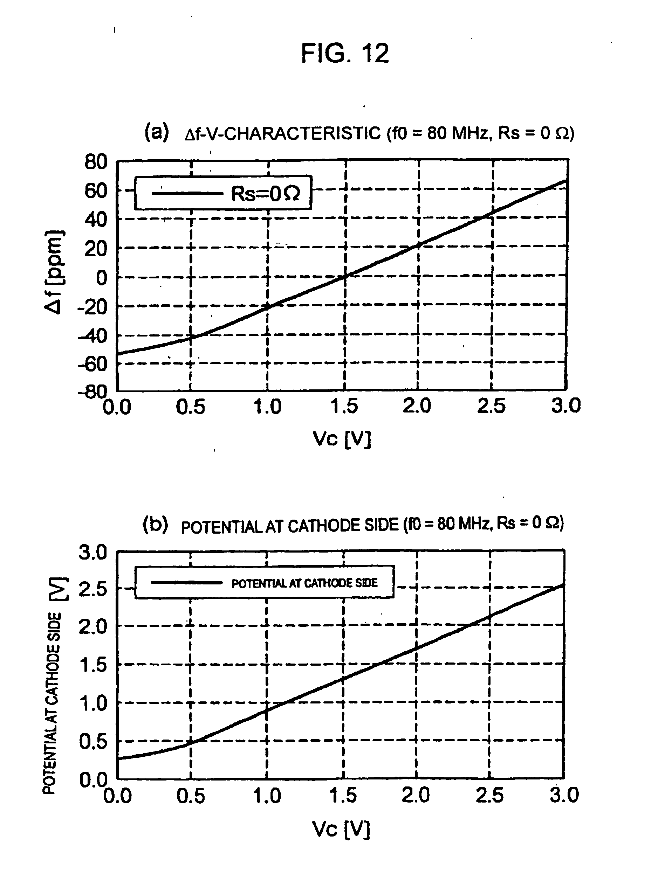

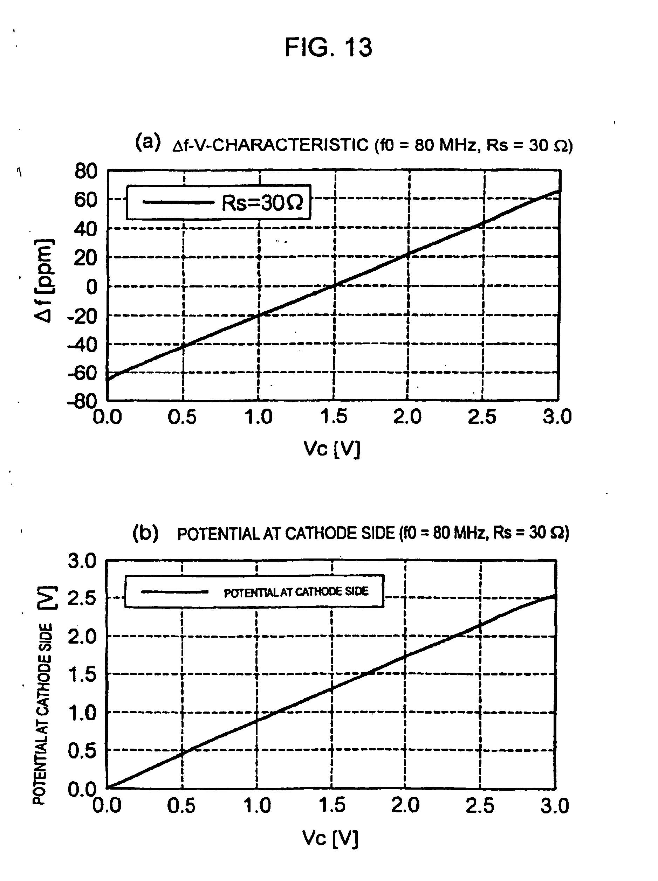

In Figs. 12 and 13, cases in which the reference frequency f0 is 80 MHz are shown.

As shown in Fig. 12, when the resistance Rs of the resistor circuit 20 is 0 Ω, the V-V-characteristic loses linearity when the control voltage Vc is approximately 0.5 V. Accordingly, the Δf-V-characteristic also loses linearity when the control voltage Vc is approximately 0.5 V. Thus, the frequency can be changed by the control voltage Vc within a range from -40 to 65 ppm.

When the resistance Rs of the resistor circuit 20 is set to 30 Ω, as shown in Fig. 13, the potential at the cathode side changes linearly with Vc. Accordingly, the Δf-V-characteristic is linear. Thus, the frequency can be changed by the control voltage Vc within a range of ±70 ppm.

Concerning the resistor circuit 20, the resistance of the resistors Rs1 to Rsn which form the resistor circuit 20 are 10 Ω to 100 Ω, respectively, and the resistor circuit 20 is incorporated into the IC chip 15. Accordingly, the same IC chip 15 can handle different resonators X with different oscillation frequencies f. For the same reason, the same IC chip 15 can handle various oscillation frequencies f, and the cost is greatly reduced.

### [1.6] Advantages of First Embodiment

According to the first embodiment, the resistor circuit 20, which can change the impedance of the oscillator loop, is connected to the oscillator loop. An appropriate one is selected from among the resistors Rs1 to Rsn of the resistor circuit 20 in order to make the oscillation amplitude smaller than the forward voltage of the varactor Cv, thereby preventing the oscillation amplitude from being clipped by the forward voltage. Thus, even when the control voltage Vc is set to a low level, a change in capacitance of the varactor Cv has correspondence with the control voltage Vc. Also, the range of the Δf-V-characteristic within which the frequency can be changed linearly by the control voltage VC is increased.

Since the VCO 10 includes the memory 30 and the control circuit 40, the resistor of the resistor circuit 20 can be confirmed after the VCO 10 is assembled. Also, the adjustment of frequency variable range can be changed in accordance with a request from a user.

### [2] Second Embodiment

In Fig. 14, a diagram showing the principle of a second embodiment is illustrated. The same reference numerals are given to components corresponding to those in the first embodiment, and a repeated description of the common portions is omitted.

The VCO 10A of the second embodiment is **characterized in that** a structure is employed which, instead of using semiconductor devices to form the switches SW1 to SWn of the resistor circuit 20, uses bonding wires to connect bonding pads exposed on the IC chip 15 to lands on a board, and selects the resistor (so-called bonding option).

In the VCO 10A, the components other than the resonator X and the varactor Cv are formed as an IC chip. On this IC chip, bonding option pads for (confirming) selecting the one or more of the resistors Rs1 to Rsn are formed.

Concerning the VCO 10A, the pads and the lands are connected to each other by the bonding wires in order to select the resistors prior to mold-sealing and assembling the IC chip, the resonator X, and the varactor Cv.

According to the VCO 10A, the appropriate resistor(s) is (are) appropriately confirmed, and hence the linear region of the Δf-V-characteristic is expanded. As a result, the range of frequencies that can be varied linearly by the control voltage Vc is increased.

Since the VCO 10A does not include the memory 30 and the control circuit 40, the area of the IC chip is minimized, and the number of components is reduced.

### [3] Third Embodiment

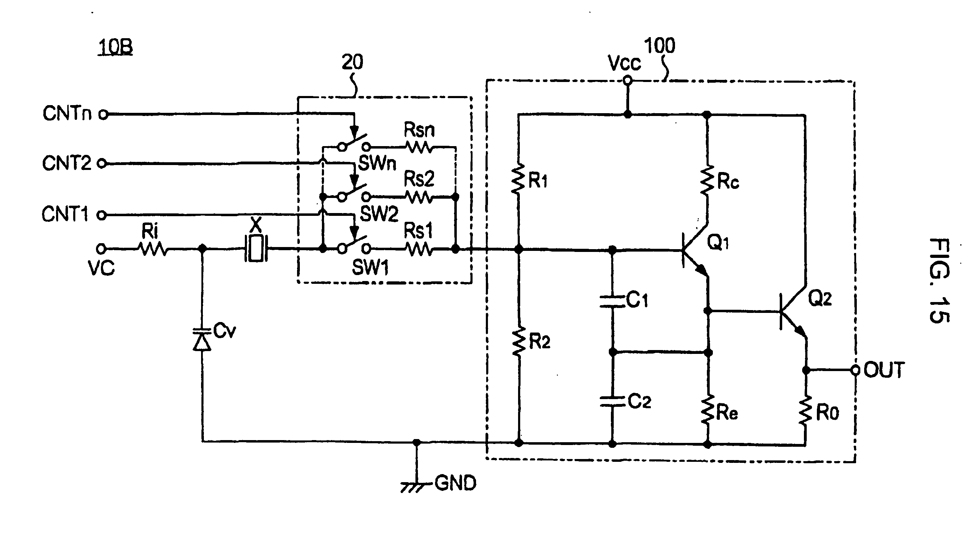

In Fig. 15, a diagram showing the principle of a third embodiment is illustrated. The same reference numerals are given to components corresponding to those in the first embodiment, and a repeated description of the common portions is omitted.

The VCO 10B of the third embodiment is **characterized in that** control terminals CNT1' to CNTn', to which a control voltage for activating the switches SW1 to SWn is applied, are exposed to the outside of the IC.

In the VCO 10B, the control voltage applied from the outside through the control terminals CNT1' to CNTn' is used to select the resistor Rs.

Concerning the VCO 10B, the resistor is appropriately selected by a selection signal from the outside, and hence the range of frequencies that can be varied linearly by the control voltage Vc is increased.

Since the VCO 10B does not include the memory 30 and the control circuit 40, the area of the IC chip is minimized, and the number of components is reduced.

### [4] Modification

### [4.1] First Modification

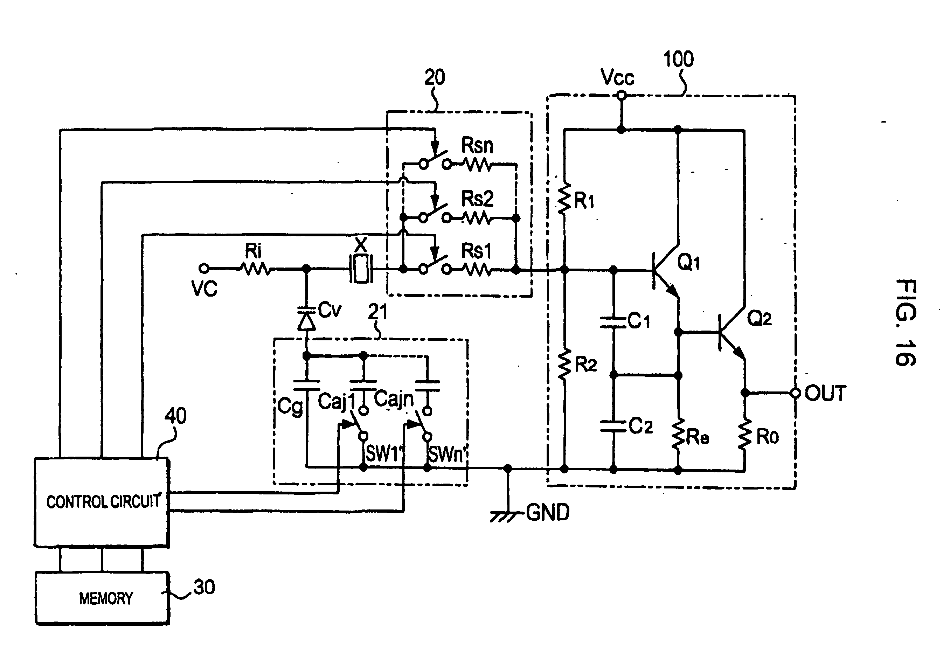

In the foregoing embodiments, it is impossible to compensate for any difference between the reference frequency f0 when Vc = Vc0 and the actual frequency f0' when Vc = Vc0 caused by varia ons in the resonator X, IC, and the like. As shown in Fig. 16, a frequency setting circuit 21 can be connected to the anode side of the varactor Cv. The frequency setting circuit 21 includes a base capacitor Cg which functions as a fixed-capacitance element, n capacitors Ca1 to Can which function as selectable-capacitance elements, and switches SW1' to SWn' which connect the capacitors Ca1 to Can in parallel.

By appropriately setting the effective capacitance of the frequency setting circuit 21, the actual frequency f0' when Vc = Vc0 can be adjusted to the reference frequency f0.

### [4.2] Second Modification

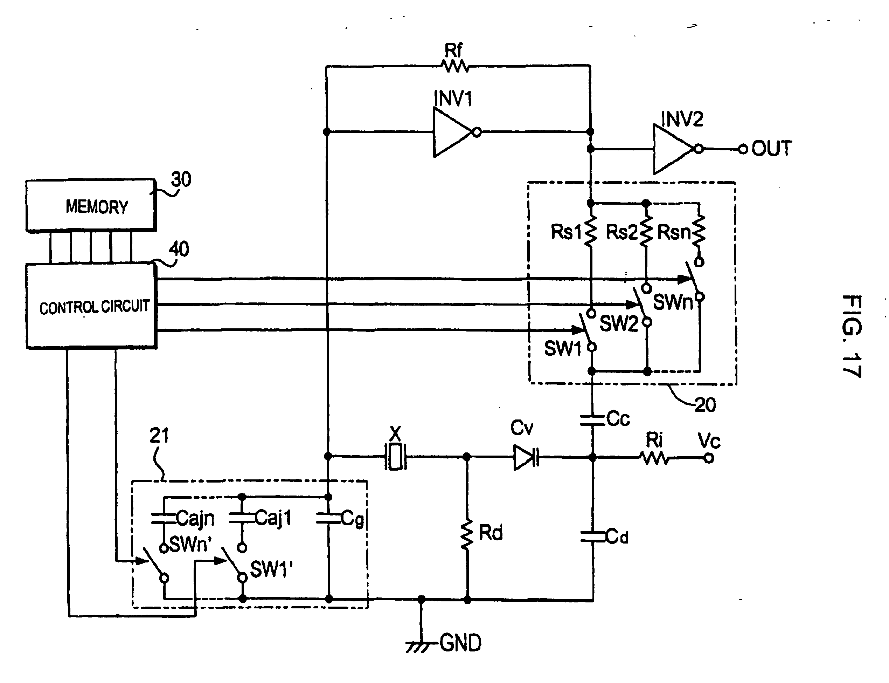

In Fig. 17, a block diagram of the VCO of this modification is shown. This VCO differs from the foregoing embodiments in that a CMOS oscillator circuit including a CMOS inverter INV is used as the oscillator circuit and that a resistor circuit 20, similar to that of the first embodiment, is applied to the CMOS oscillator circuit. When the present invention is applied to the CMOS oscillator circuit, it is possible to achieve advantages similar to those in the first embodiment.

By connecting the frequency setting circuit 21 of the first modification, the reference frequency f0 can be adjusted.

### [4.3] Third Modification

According to the VCO 10 of the first embodiment, the components other than the resonator X and the varactor Cv are formed as the IC chip 15, and the IC chip 15, the resonator X, and the varactor Cv are mold-sealed. However, the present invention is not limited to this structure. As shown in Fig. 18, the components (including the varactor Cv) other than the resonator X are formed as an IC chip 16, and the IC chip 16 and the resonator X can be mold-sealed.

### [4.4] Fourth Modification

In the first embodiment, when the adjusting device 50 is used to select the appropriate resistor, the operator monitors the Af-V-characteristics and thereafter confirms the desired resistor. However, the present invention is not limited to this embodiment. By determining whether or not a differential value obtained by differentiating the measured frequency deviation Δf exceeds a threshold value, the resistor can be automatically confirmed. As long as the linearity of Δf-V-characteristic is improved, any method for confirming the resistor can be used.

### [4.5] Fifth Modification

In the foregoing embodiments, the range of frequency that can be varied by the control voltage Vc is increased by improving the linearity of Δf-V-characteristic. In contrast, when it is possible to know the relationship between the resistor Rs and that characteristic in advance, particularly the point at which the frequency deviation Δf becomes constant after the characteristic became nonlinear, then it is possible to set, for example, a region in which the control voltage Vc is Vc1 or greater as a range in which the frequency can be changed, and a region in which the control voltage Vc is Vc1 or smaller as a range in which the frequency does not vary.

### [Advantages]

According to the present invention, the linearity of Δf-V-characteristic can be improved, and the range of frequency that can be varied by a control voltage can be increased.

## Claims

1. A voltage-controlled oscillator comprising:
a piezoelectric resonator (X);
a variable capacitance diode (Cv) connected in series to said resonator (X);
an oscillator circuit (100) connected to said variable capacitance diode (Cv); and
a resistor circuit (20) provided in an oscillator loop including said resonator (X), said variable capacitance diode (Cv), and said oscillator circuit (100), said resistor circuit (20) comprising a plurality of resistors (Rs1-Rsn) which are selectively inserted, wherein said resistor circuit (20) comprises switch means (SW1-SWn) for connecting or disconnecting the resistors (Rs1-Rsn) based on a first control signal (SC1-SCn),
the oscillator further comprising:
a memory (30) for storing control data; and
a control circuit (40) for storing control data beforehand in said memory (30), based on a second control signal (Rcon1-Rconn) which is supplied from the outside, and for outputting said first control signal (SC1-SCn) for controlling said switch means (SW1-SWn) based on said second control signal (Rcon1-Rconn) or the control data.

2. The oscillator according to claim 1, wherein said switch means (SW1-SWn) comprise semiconductor switches.

3. The oscillator according to claim 1, wherein said resistor circuit (20) has one end of each of its resistors (Rs1-Rsn) connected to the oscillator loop and the other end connected to a bonding pad.

4. The oscillator according to any one of the preceding claims, further comprising;
a capacitor circuit (21) connected to said variable capacitance diode (Cv), said capacitor circuit comprising a plurality of selectable capacitance elements (Caj1-Cajn); and
a capacitance connecting circuit (SW1'-SWn') for connecting to said variable capacitance diode (Cv) a desired capacitive element from among the selectable capacitance elements (Caj1-Cajn).

5. The oscillator according to any one of the preceding claims, wherein said resonator (X) is a crystal resonator.

6. The oscillator according to any one of the preceding claims, wherein components other than said resonator (X) and said variable capacitance diode (Cv) are formed as an IC chip (15).

7. The oscillator according to claim 6, wherein said IC chip (15), said resonator (X), and said variable capacitance diode (Cv) are integrally mold-sealed.

8. The oscillator according to claim 6, wherein said IC chip (15), said resonator (X), and said variable capacitance diode (Cv) are contained in a single package.

9. The oscillator according to claim 6, wherein said resonator (X) and said variable capacitance diode (Cv) are integrally mold-sealed.

10. The oscillator according to claim 6, wherein said resonator (X) and said variable capacitance diode (Cv) are contained in a single package.

11. The oscillator according to any one of the preceding claims, wherein components other than said resonator (X) are formed as an IC chip (16).

12. The oscillator according to claim 11, wherein said IC chip (16) and said resonator (X) are integrally mold-sealed.

13. The oscillator according to claim 11, wherein said IC chip (16) and said resonator (X) are contained in a single package.

## Patentansprüche

1. Spannungsgesteuerter Oszillator, der aufweist:
einen piezoelektrischen Resonator (X):
eine variable Kapazitätsdiode (Cv), die in Reihe mit dem Resonator (X) verbunden ist;
eine Oszillatorschaltung (100), die mit der variablen Kapazitätsdiode (Cv) verbunden ist; und
eine Widerstandsschaltung (20), die In einer Oszillator-Schleife vorgesehen ist, die den Resonator (X), die variable Kapazitatsdiode (Cv) und die Oszlilatorschaitung (100) umfasst, wobei die Widerstandsschaltung (20) eine Vielzahl von Widerständen (Rs1-Rsn) aufweist, die selektiv eingefügt sind, wobei die Widerstandsschaltung (20) Schaltungsmittel (SW1-SWn) aufweist zum Verbinden oder Trennen der Widerstände (Rs1-Rsn) basierend auf einem ersten Steuerungssignal (SC1-SCn),
wobei der Oszillator welter aufweist:
einen Speicher (30) zum Speichern von Steuerungsdaten; und
eine Steuerungsschaltung (40) zum Speichern von Steuerungsdaten im Voraus In dem Speicher (30), basierend auf einem zweiten Steuerungssignal (Rcon1-Rconn), das von außerhalb geliefert wird, und zum Ausgeben des ersten Steuerungssignals (SC1-SCn) zum Steuern der Schaltungsmittel (SW1-SWn) basierend auf dem zweiten Steuerungssignal (Rcon1-Rconn) oder den Steuerungsdaten.

2. Oszillator gemäß Anspruch 1, wobei die Schaltungsmittel (SW1-SWn) Halbleiterschalter aufweisen.

3. Oszillator gemäß Anspruch 1, wobei bei der Widerstandsschaltung (20) ein Ende von jedem ihrer Widerstände (Rs1-Rsn) mit der Oszillator-Schleife verbunden ist und das andere Ende mit einem Bonding-Pad verbunden Ist.

4. Oszillator gemäß einem der vorhergehenden Ansprüche, der weiter aufweist:
eine Kondensatorschaltung (21), die mit der variablen Kapazitätsdiode (Cv) verbunden ist, wobei die Kondensatorschaltung eine Vielzahl von auswählbaren Kapazitätselementen (Caj1-Cajn) aufweist; und
eine Kapazitätsverbindungsschaltung (SW1'- SWn') zum Verbinden mit der varlablen Kapazitatsdiode (Cv) eines gewünschten kapazitiven Elements aus den auswählbaren Kapazitätselementen (Caj1-Cajn).

5. Oszillator gemäß einem der vorhergehenden Ansprüche, wobei der Resonator (X) ein Kristallresonator Ist.

6. Oszillator gemäß einem der vorhergehenden Ansprüche, wobei Komponenten, außer dem Resonator (X) und der variablen Kapazitätsdiode (Cv), als ein IC-Chip (15) ausgebildet sind.

7. Oszillator gemäß Anspruch 6, wobei der IC-Chip (15), der Resonator (X) und die variable Kapazitätsdiode (Cv) integral Guss-abgedichtet sind.

8. Oszillator gemäß Anspruch 6, wobei der IC-Chip (15), der Resonator (X) und die variable Kapazitätsdiode (Cv) in einem einzigen Gehäuse enthalten sind.

9. Oszillator gemäß Anspruch 6, wobei der Resonator (X) und die variable Kapazitätsdiode (Cv) integral Guss-abgedlchtet sind.

10. Oszillator gemäß Anspruch 6, wobei der Resonator (X) und die variable Kapazitätsdiode (Cv) in einem einzigen Gehäuse enthalten sind.

11. Oszillator gemäß einem der vorhergehenden Ansprüche, wobei Komponenten, außer dem Resonator (X), als ein IC-Chip (16) ausgebildet sind.

12. Oszillator gemäß Anspruch 11, wobei der IC-Chip (16) und der Resonator (X) integral Guss-abgedichtet sind.

13. Oszillator gemäß Anspruch 11, wobei der IC-Chip (16) und der Resonator (X) in einem einzigen Gehäuse enthalten sind.

## Revendications

1. Oscillateur commandé en tension et comprenant:
un résonateur (X) piézoélectrique ;
une diode (Cv) formant capacité variable montée en série avec le résonateur (X) ;
un circuit (100) d'oscillateur relié à la diode (Cv) de capacité variable ; et
un circuit (20) de résistance prévu dans une boucle d'oscillateur comprenant le résonateur (X), la diode (Cv) de capacité variable et le circuit (100) d'oscillateur, le circuit (20) de résistance comprenant une pluralité de résistances (Rs1 à Rsn) qui sont insérées sélectivement, dans lequel le circuit (20) de résistance comprend des moyens (SW1 à SWn) de commutation pour connecter ou déconnecter les résistances (Rs1 à Rsn) sur la base d'un premier signal (SC1 à SCn) de commande,
l'oscillateur comprenant, en outre :
une mémoire (30) pour mémoriser des données de commande ; et
un circuit (40) de commande pour mémoriser des données de commande à l'avance dans la mémoire (30) sur la base d'un deuxième signal (Rcon1 à Rconn) de commande, qui est fourni de l'extérieur, et pour sortir le premier signal (SC1 à SCn) de commande pour commander les moyens (SW1 à SWn) de commutation sur la base du deuxième signal (Rcon1 à Rconn) de commande ou des données de commande.

2. Oscillateur suivant la revendication 1, dans lequel les moyens (SW1 à SWn) de commutation comprennent des commutateurs à semiconducteur.

3. Oscillateur suivant la revendication 1, dans lequel le circuit (20) de résistance a une extrémité de chacune de ses résistances (Rs1 à Rsn) reliée à la boucle d'oscillateur et l'autre extrémité reliée à une plage de connexion.

4. Oscillateur suivant l'une quelconque des revendications précédentes, comprenant, en outre :
un circuit (21) de condensateur relié à la diode (Cv) de capacité variable, le circuit de condensateur comprenant une pluralité d'éléments (Caj1 à Cajn) de capacité pouvant être sélectionnés ; et
un circuit (SW1' à SWn') de connexion de capacité pour connecter à la diode (Cv) de capacité variable un élément capacitif souhaité parmi les éléments (Caj1 à Cajn) de capacité pouvant être sélectionnés.

5. Oscillateur suivant l'une quelconque des revendications précédentes, dans lequel le résonateur (X) est un résonateur à cristal.

6. Oscillateur suivant l'une quelconque des revendications précédentes, dans lequel des composants autres que le résonateur (X) et la diode (Cv) de capacité variable sont sous la forme d'une puce (15) à circuit intégré.

7. Oscillateur suivant la revendication 6, dans lequel la puce (15) à circuit intégré, le résonateur (X) et la diode (Cv) de capacité variable sont scellés par moulage intégralement.

8. Oscillateur suivant la revendication 6, dans lequel la puce (15) à circuit intégré, le résonateur (X) et la diode (Cv) de capacité variable sont contenus dans une boîtier unique.

9. Oscillateur suivant la revendication 6, dans lequel le résonateur (X) et la diode (Cv) de capacité variable sont scellés par moulage intégralement.

10. Oscillateur suivant la revendication 6, dans lequel le résonateur (X) et la diode (Cv) de capacité variable sont contenus dans un boîtier unique.

11. Oscillateur suivant l'une quelconque des revendications précédentes, dans lequel les composants autres que le résonateur (X) sont sous la forme d'une puce (16) à circuit intégré.

12. Oscillateur suivant la revendication 11, dans lequel la puce (16) à circuit intégré et le résonateur (X) sont scellés par moulage intégralement.

13. Oscillateur suivant la revendication 11, dans lequel la puce (16) à circuit intégré et le résonateur (X) sont contenus dans un boîtier unique.
